# EUROPEAN PATENT SPECIFICATION

(11) **EP 4 485 790 B1**
(45) Date of publication and mention of the grant of the patent: **13.05.2026**
(21) Application number: 24184466.1
(22) Date of filing: 25.06.2024
(51) Int. Cl.: H02N 2/00, H02N 2/02, G02B 7/08, G02B 7/10, H10N 30/073

(54) **VIBRATION-TYPE ACTUATOR AND ELECTRONIC APPARATUS**
VIBRATIONSAKTUATOR UND ELEKTRONISCHE VORRICHTUNG
ACTIONNEUR DE TYPE À VIBRATION ET APPAREIL ÉLECTRONIQUE

(30) Priority: 26.06.2023 JP 2023104586
(43) Date of publication of application: 01.01.2025
(73) Proprietor: CANON KABUSHIKI KAISHA, Tokyo 146-8501 (JP)
(72) Inventor: SHIMADA, Akira, Tokyo, 146-8501 (JP)
(74) Representative: Canon Europe Limited

(56) References cited:
- WO-A1-2022/230712
- JP-A- 2014 217 143
- US-A1- 2023 060 963
- DESHPANDE L S ET AL: "Observations in the flat lapping of stainless steel and bronze", WEAR, ELSEVIER SEQUOIA, LAUSANNE, CH, vol. 265, no. 1-2, 7 November 2007 (2007-11-07), pages 105 - 116, XP022574866, ISSN: 0043-1648

## Description

### TECHNICAL FIELD

The present disclosure relates to a vibration-type actuator and an electronic apparatus including the vibration-type actuator.

### BACKGROUND

### Description of the Related Art

Japanese Patent No. 5930595 discusses a vibration wave motor using, as a vibration generation source, an electro-mechanical energy conversion element, such as a piezoelectric element. The vibration wave motor includes a vibrator and a contact body. The vibrator includes a plate-type elastic body and a piezoelectric element fixed to the reverse side of the elastic body. The elastic body has an upper surface provided with two protrusions arranged on it. The contact body is in pressure contact with the protrusions.

In this vibration wave motor, a predetermined alternating voltage is applied to the electro-mechanical energy conversion element.

This excites two bending vibrations (standing waves) to generate an elliptic, or circular, motion at the ends of the protrusions (e.g., including a contact surface of each protrusion that is arranged in pressure contact with the contact portion). The motion occurs in a plane which includes directions which connect the two protrusions (e.g., a direction which intersects both protrusions), and a protruding direction of the protrusion. The contact body that is in pressure contact with the protrusions then receives frictional drive force (thrust force) from the two projections, which makes it possible to relatively move the vibrator and the contact body in a direction that connects the two protrusions.

On the other hand, actuators, such a vibration wave motor, have been demanded to be smaller in size and drive larger objects in order to downsize electronic apparatuses, which means high-power densification in actuators. A known vibration-type actuator is described in JP2014217143A.

With the trend toward the high-power densification in vibration wave motors, there is a concern that an adhesive that is generally used to bond a piezoelectric element and an elastic body can be peeled due to higher stress applied to the vibrator.

### SUMMARY

In view of such an issue, the present disclosure is directed to providing a vibration wave motor with high output power and adhesion reliability and an electronic apparatus including the vibration wave motor.

According to a first aspect of the present disclosure, there is provided a vibration-type actuator comprising: a vibration body including an electro-mechanical energy conversion element and an elastic body which are bonded to each other via an adhesive; and a contact body in contact with the elastic body, wherein the vibration body and the contact body are configured to be relatively moved by vibrations of the vibration body, wherein the elastic body includes: a flat plate portion that is bonded to the electro-mechanical energy conversion element via the adhesive; and a protrusion that is continuous to the flat plate portion and that protrudes from the flat plate portion, the vibration-type actuator further comprising: as part of the adhesive, between the electro-mechanical energy conversion element and the flat plate portion, a first adhesive layer; and a second adhesive layer that is adjacent to the first adhesive layer, a thickness of the second adhesive layer being larger than a thickness of the first adhesive layer and increasing toward the protrusion, or a third adhesive layer that is adjacent to the first adhesive layer and that is between the first adhesive layer and an edge portion of the electro-mechanical energy conversion element, a thickness of the third adhesive layer increasing toward the edge portion and being 10 µm or less, and a length of the third adhesive layer being between 100 µm and 400 µm.

According to a second aspect, there is provided an optical apparatus comprising: the vibration-type actuator according to the first aspect; and at least one of an optical element and an image pickup element configured to be driven by the vibration-type actuator.

According to a third aspect there is provided an electronic apparatus comprising: a member; and the vibration-type actuator according to the first aspect. The vibration-type actuator being configured to drive the member.

Optional features will now be set out. These are applicable singly or in any combination with any aspect of the disclosure.

The thickness of the second adhesive layer may be between 3 µm and 10 µm.

A curved portion of the elastic body comprising a curved surface different from a linear surface of the flat plate portion that is adjacent to the second adhesive layer may be formed at a root of the protrusion.

A length in a radial direction of the protrusion on the second adhesive layer in a section from an end portion of the first adhesive layer adjacent to the second adhesive layer to a point where the curved portion abuts the flat plate portion may be between 100 µm and 400 µm.

The vibration-type actuator may further comprise an adhesive pool that is adjacent to the second adhesive layer not on the first adhesive layer side.

The elastic body may be made of martensite stainless steel. The elastic body may be arranged on the electro-mechanical energy conversion element side. The surface may comprise a microstructure which is configured by quenching the surface after rolling. A surface roughness Ra of the surface may be between 0.025 µm and 0.2 µm.

The vibration-type actuator may be configured such that a difference between a maximum value and minimum value of a thickness of the flat plate portion may be 10 µm or less.

Any feature in one aspect of the disclosure may be applied to other aspects of the disclosure, in any appropriate combination.

Further features of the present disclosure will become apparent from the following description of examples with reference to the attached drawings.

### BRIEF DESCRIPTION OF THE DRAWINGS

Fig. 1 is an exploded perspective view of a vibration wave motor in a first example of the present disclosure.
Fig. 2 is a perspective view of an assembly of the vibration wave motor in the first example of the present disclosure.
Fig. 3 is a perspective view for describing vibration modes in the first example of the present disclosure.
Fig. 4A is a top view of a vibrator in the first example of the present disclosure. Fig. 4B is a cross-sectional view of the vibrator in the first example of the present disclosure. Fig. 4C is an enlarged cross-sectional view illustrating the neighborhood of a rising portion of a protrusion. Fig. 4D is an enlarged view illustrating the neighborhood of an edge of a flat plate portion.
Fig. 5 is a view illustrating a region of each adhesive layer in the vibrator in the first example of the present disclosure.
Fig. 6 is a view illustrating a shear stress applied to an adherend surface of the elastic body in each vibration mode in the first example of the present disclosure.
Fig. 7A is a top view illustrating a schematic configuration of an imaging device (electronic apparatus) using a vibration wave motor in a second example of the present disclosure. Fig. 7B is a block diagram illustrating a schematic configuration of the imaging device (electronic apparatus) using the vibration wave motor in the second example of the present disclosure.

### DESCRIPTION OF THE EMBODIMENTS

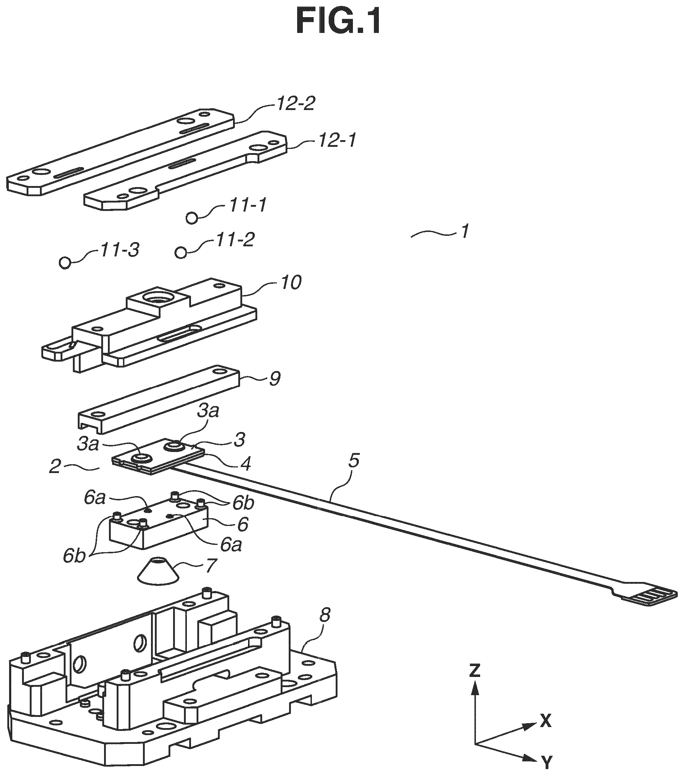

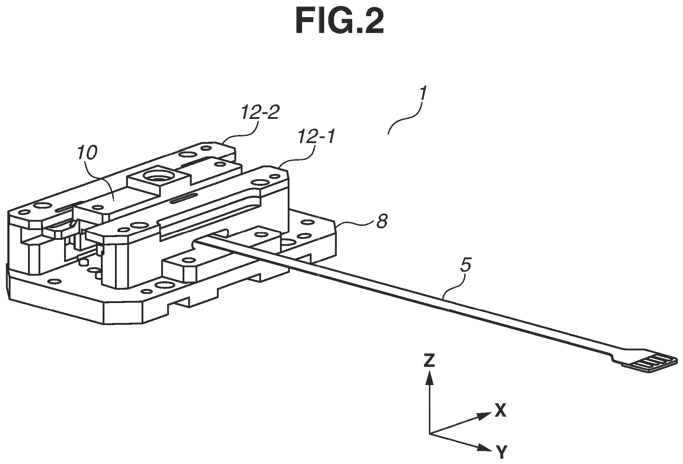

A first example will be descried in detail as an example in which the present disclosure is applied to a linear-type vibration wave motor with reference to Figs. 1 to 6. First, Fig. 1 is an exploded perspective view of a vibration wave motor 1 in a first example of the present disclosure. Fig. 2 is a perspective view of an assembly of the vibration wave motor 1. The driving direction of a slider 9 serving as a contact body (e.g., direction of the relative movements of a vibrator 2, which will be described below, and the slider 9) is an "X-direction" (or simply referred to as "X"). The direction in which the slider 9 is in pressure contact with the vibrator 2 (e.g., a pressing direction) is a "Z-direction" (or simply referred to as "Z"). Additionally, a direction that is orthogonal to the X-direction and the Z-direction is defined as a "Y-direction" (or simply referred to as "Y").

A piezoelectric element 4, which is an electro-mechanical energy conversion element, is fixed to an elastic body 3 via an adhesive, and, furthermore, a flexible printed board 5 is electrically connected to the piezoelectric element 4 on the surface opposite to the surface on which the elastic body 3 is provided. The elastic body 3, the piezoelectric element 4, and the flexible printed board 5 constitute the vibrator 2. The flexible printed board 5 is fixed to the piezoelectric element 4 with an anisotropic conductive paste or an anisotropic conductive film that enables energization only in the Z-direction. The elastic body 3 is formed of two protrusions 3a that protrude on the opposite side of the piezoelectric element 4 and a flat plate portion 3b in a plate shape.

Lead zirconate titanate is used for the piezoelectric element 4. Alternatively, the piezoelectric element 4 can be composed mostly of a piezoelectric material not containing lead, such as barium titanate or bismuth sodium titanate, that is, a piezoelectric material whose lead content is 1000 ppm or less. On both surfaces of the piezoelectric element 4, an electrode pattern 4a is formed, and power is supplied from the flexible printed board 5 via the electrode pattern 4a.

A pressure member 6 that presses and supports the vibrator 2 is provided under the vibrator 2. A force of pressure is applied to the pressure member 6 by a pressure spring 7, and the reaction force is received by a base 8 serving as a pressure receiving member. A conical coil spring is used as the pressure spring 7 to downsize the vibration wave motor 1 in the Z-direction. The coil shape is illustrated in a simplified manner.

The slider 9 is provided over the vibrator 2 and is in pressure contact with the elastic body 3. The slider 9 is fixed to a slider holder 10, and is driven integrally with the slider holder 10 in the X-direction. Rubber can be provided between the slider 9 and the slider holder 10 to attenuate vibrations. The slider 9 is composed of metal, ceramic, resin, or a composite material thereof, all of which have high abrasion resistance. Especially, a material obtained by nitriding a stainless steel, such as SUS420J2, is favorable in terms of abrasion resistance and mass production.

Three balls 11 are interposed between the slider holder 10 and three pairs of upper and lower rails provided in ball rails 12 fixed to the base 8, allowing movement of the slider 9 and the slider holder 10 with respect to the other components in the X-direction. An output transmission portion having a desired shape attached to the slider holder 10 transmits output to the outside. While the example of fixing the vibrator 2 and moving the slider 9 is described, it is also possible to fix the slider 9 and move the vibrator 2.

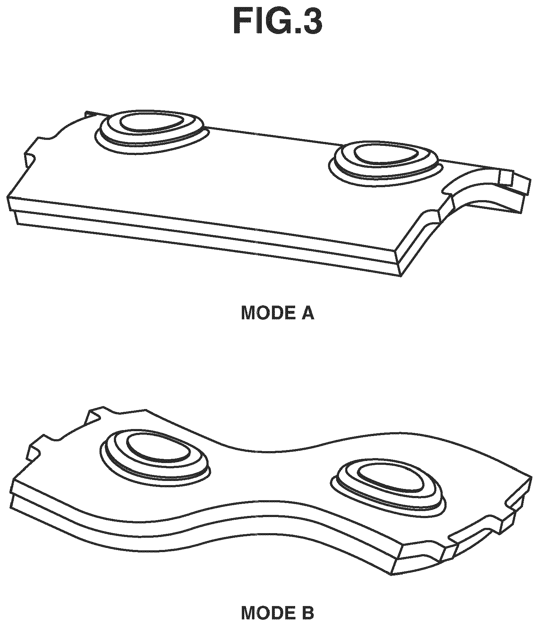

Subsequently, vibration modes excited by the vibrator 2 are described with reference to Fig. 3. In the present example, applying two alternating voltages in different phases to the piezoelectric element 4 through the flexible printed board 5 excites two out-of-plane bending vibrations in different phases in the vibrator 2, and generates vibrations that combines these two vibrations.

A mode A, which is a first vibration mode, is a primary out-of-plane bending vibration mode in which two nodes appear in parallel in the X-direction, which is a longitudinal direction of the vibrator 2. Each protrusion 3a is at a position where a vibration amplitude reaches a maximum in the Z-direction in the mode A, that is, at an antinode position, and vibrations in the mode A displace each of the two protrusions 3a in the Z-direction, which is a pressure direction. A mode B, which is a second vibration mode, is a secondary out-of-plane bending vibration mode in which three nodes appear in approximately parallel in the Y-direction, which is a shorthand direction of the vibrator 2. Each protrusion 3a is at a position where a vibration amplitude reaches a minimum in the Z-direction in the mode B, that is, at a node position, and vibrations in the mode B displace each of the two protrusions 3a in the X-direction.

By combining the vibrations in the modes A and B, the two protrusions 3a generate an elliptic motion or a circular motion in a Z-X plane. Bringing the slider 9 in pressure contact with the two protrusions 3a generates a friction force in the X-direction to generate a driving force (thrust force) that relatively moves the vibrator 2 and the slider 9. In the present example, the vibrator 2 is held by a method to be described below, so that the slider 9 is driven in the X-direction.

To efficiently drive the vibration wave motor 1, it is necessary to apply pressure to the vibrator 2 without inhibiting vibrations (displacements) in the two vibration modes excited by the vibrator 2. To achieve this, it is desirable to support the neighborhood of nodes in the two vibration modes. For this reason, two protruding portions 6a are provided on the pressure member 6 to apply pressure to and retain nodes common to the two vibration modes, whereby pressure is more efficiently applied to the vibrator 2.

Furthermore, the protruding portions 6a also play the role of holding the vibrator 2 in the X- and Y-directions. In the present example, the flexible printed board 5 and the protruding portions 6a, among the vibrator 2, are in contact with each other, and a force of pressure and a friction coefficient are adjusted so that a maximum static frictional force between the flexible printed board 5 and protruded portions 6a is always larger than a thrust force generated in the slider 9. That is, the vibrator 2 never moves with respect to the pressure member 6 during driving of the vibration wave motor 1.

Meanwhile, the pressure member 6 is provided with four loose-fit portions 6b, which support the outer circumferential surface of the vibrator 2 with play (which are loosely fit to the outer circumferential surface of the vibrator 2). These loose-fit portions 6b each fulfill a function of positioning at the time of assembly of the vibrator 2, and a function as a stopper when some external force acts on the slider 9.

Additionally, there is a possibility that the loose-fit portions 6b are in contact with the vibrator 2 at respective two locations that are different from locations of nodes of vibrations on the outer circumferential surface of the vibrator 2. However, as described above, the maximum static frictional force between the flexible printed board 5 and the protruding portions 6a is larger than the thrust force generated in the slider 9, so that forces in the X- and the Y-directions do not act on a contact portion between each loose-fit portion 6b and the vibrator 2. For this reason, a loss here is negligible, producing no issue regarding driving.

Since the protruding portions 6a of the pressure member 6 and the neighborhood of the nodes of the vibrator 2 are in direct contact with each other and the loose-fit portions 6b and the outer circumferential surface of the vibrator 2 are in direct contact with each other, the material of the pressure member 6 is desirably resin having high vibration isolation properties to prevent occurrence of noise. Each protruding portion 6a desirably has a larger friction coefficient to increase the force of holding the vibrator 2 for the above-mentioned reasons. Meanwhile, each loose-fit portion 6b desirably has a smaller friction coefficient to reduce the frictional loss between each loose-fit portion 6b and the vibrator 2. For the above-mentioned reasons, it is also possible to separately apply a coating for increasing the friction coefficient to the protruding portions 6a, and a coating for decreasing the friction coefficient to the loose-fit portions 6b. Additionally, it is also possible to use different components having respectively appropriate friction coefficients by adhesive bonding or press-fitting.

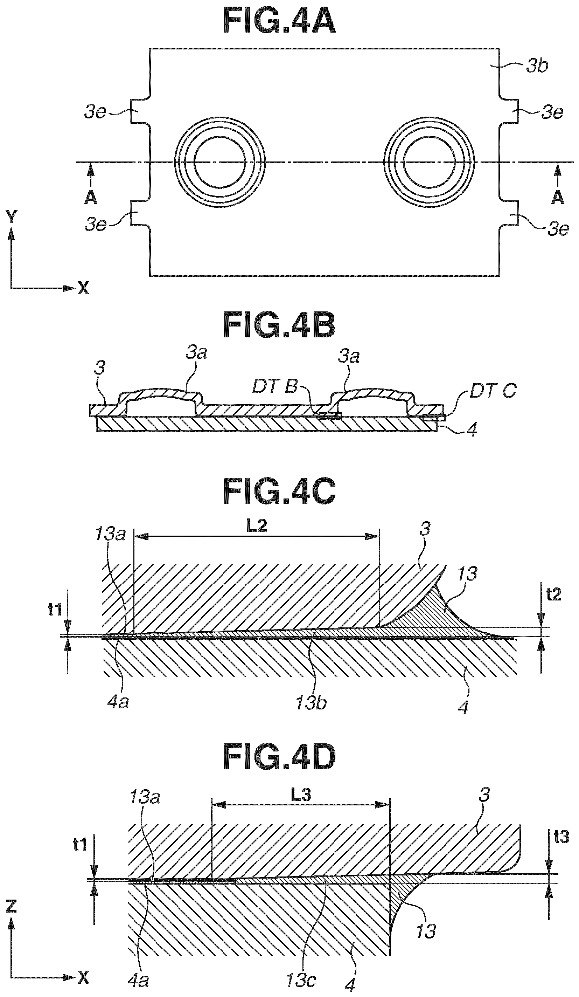

Subsequently, details of the vibrator 2 will be described with reference to Figs. 4A to 4D. Fig. 4A is a top view of the vibrator 2. Fig. 4B is a cross-sectional view taken along an A-A line illustrated in Fig. 4A. Each protruding portion 3a formed on the elastic body 3 has a hollow shape, and has springiness (flexibility) in the pressure direction. This springiness allows smooth contact between the vibrator 2 and the slider 9, preventing the occurrence of noise.

Fig. 4C is an enlarged view illustrating a B-portion illustrated in Fig. 4B. Fig. 4D is an enlarged view illustrating a C-portion illustrated in Fig. 4B. There is an adhesive 13 between the flat plate portion 3b of the elastic body 3 and the piezoelectric element 4. In some cases, the adhesive layer is too thick, such that it attenuates vibrations of the vibrator 2. In other cases, the adhesive layer is too thin such that it decreases adhesive strength. Thus, the thickness of part of the adhesive layer, that is, the thickness of a first adhesive layer 13a that occupies the major portion of the adhesive layer desirably falls between 0 µm and 3 µm. The thickness of 0 µm herein means that the elastic body 3 and the piezoelectric element 4 are in contact with each other. Due to minute irregularities, undulations, a warpage on the surface, the adhesive layer has a certain level of distribution in thickness.

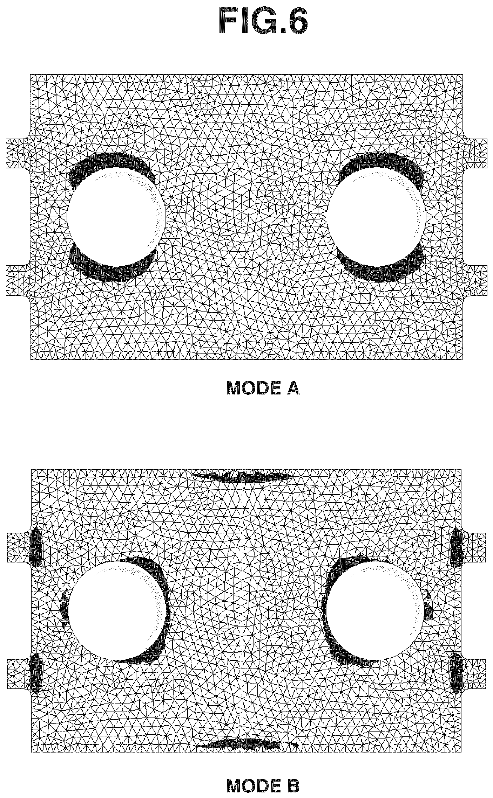

Respective results of calculation of shear stress on the bonded surface of the elastic body 3 in the modes A and B in simulations are illustrated in Fig. 6. In Fig. 6, each component is divided into meshes for calculation, and meshes in a location in which a shear stress is relatively high are filled with black. As a matter of course, the shear stress is calculated with the piezoelectric element 4 included in it, but the piezoelectric element 4 is not illustrated in Fig. 6 for simplicity. It is understood from Fig. 6 that the shear stress is higher around the root of each protrusion 3a and around the edge of each rectangular portion.

To relax the shear stress around each protrusion 3a, a second adhesive layer 13b is provided. The second adhesive layer 13b is adjacent to the first adhesive layer 13a and its thickness gradually increases toward each protrusion 3a. The thickness of the second adhesive layer 13b falls between 3 µm and 10 µm. Making the thickness of the second adhesive layer 13b larger than the thickness of the first adhesive layer 13a relaxes the stress acting on the bonded layer. Additionally, gradually larger thicknesses of the second adhesive layer 13b prevent localized stress concentration. In some cases, a too short length as a length (L2) in a radial direction of the second adhesive layer 13b decreases the effect of the stress relaxation, and a too long length attenuates vibrations. Thus, the length of the second adhesive layer 13b desirably falls between 100 µm and 400 µm.

Such an appropriately defined length in the radial direction of the protrusion 3a on the second adhesive layer 13b in a section between an end portion of the first adhesive layer 13a and an inflection point of a curved portion is expected to cause a more significant effect.

The second adhesive layer 13b is adjacent to the curved portion at the root of each protrusion 3a, but the second adhesive layer 13b and the curved portion become distinct from each other at the inflection point.

The maximum thickness of the second adhesive layer 13b illustrated as an example in Fig. 4C is t2. At the inflection point in the curved portion illustrated in Fig. 4C, a line indicating the upper end of the maximum thickness t2 and a line indicating the right end of the length (L2) intersect with each other.

A cross section of the bonded surface of the elastic body 3 within the range of the second adhesive layer 13b is distinct from the curved portion at the root of the protrusion 3a in terms of a different curvature or a linear shape.

Additionally, like the configuration illustrated in Fig. 4C, a configuration can be employed in which an adhesive pool is provided that is adjacent to the second adhesive layer 13b and is formed by further extension of the inflection point of the curved portion toward the protrusion 3a, in addition to the first adhesive layer 13a and the second adhesive layer 13b. The adhesive pool provided adjacent to the second adhesive layer 13b not on the first adhesive layer 13a side provides a robust vibration body, ensuring more expectation of the stress relaxation effect by the second adhesive layer 13b.

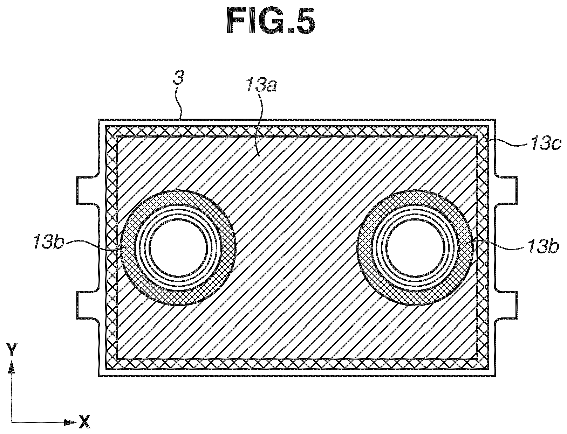

In contrast, as illustrated in Fig. 4D, to relax the stress around the edge portion of the piezoelectric element 4, a third adhesive layer 13c is provided. The third adhesive layer 13c is adjacent to the first adhesive layer 13a and its thickness gradually increases toward the edge of the flat plate portion 3b. The thickness of the third adhesive layer 13c falls between 3 µm and 10 µm. A larger thickness of the third adhesive layer 13c than the thickness of the first adhesive layer 13a relaxes a stress acting on the adhesive layer. Additionally, gradually larger thicknesses of the third adhesive layer 13c prevent localized stress concentration. A too short length as a length (L3) in the radial direction of the third adhesive layer 13c decreases the stress relaxation effect, and a too long length as the length (L3) attenuates vibrations. Desirably, the length of the third adhesive layer 13c falls between 100 µm and 400 µm. Fig. 5 illustrates the distribution of each adhesive layer, and it is understood that the portions to which relatively higher stress is applied are covered with the second adhesive layer 13b and the third adhesive layer 13c as compared with the cases in Fig. 6.

To provide the second adhesive layer 13b and third adhesive layer 13c in this manner, either the elastic body 3 or the piezoelectric element 4 is processed into a non-planar shape as described above. However, due to poor workability of the piezoelectric element 4 made of ceramic, it is more advantageous to process the elastic body 3 into a non-planar shape. The elastic body 3 can be manufactured by press work, forging, sintering, cutting, or another process, but the press work method is the most desirable in terms of cost and dimensional accuracy.

Meanwhile, to ensure the height of the protrusion 3a, there is a case where crushing is performed, and the volume of a crushed portion is caused to flow to the protrusion 3a. In this case, a shock line is formed around the protrusion 3a on the to-be-bonded surface, degrading the flatness, whereby it is necessary to perform cutting work, such as lapping after pressing. In the present example, since lapping changes the non-planar shape, the protrusion 3a is formed by adjustment of the height of the protrusion 3a without crushing. That is, the volume of the inside of the protrusion 3a from the rising portion thereof is equal before and after the formation of the protrusion 3a. With the absence of the crushing, the flatness of the to-be-bonded surface can be maintained, eliminating the need for a process, such as lapping.

As another effect brought by the absence of a certain process, such as lapping, the plate thickness of the flat plate portion 3b is stabilized, and the difference in plate thickness, that is, the difference between the maximum and minimum values of the thickness of the flat plate portion 3b, is 10 µm or less, stabilizing resonance frequencies in the modes A and B of the vibrator 2.

The elastic body 3 is desirably made of a material with lower vibration attenuation, such as metal. An especially desirable material is martensite stainless steel, which is convenient because martensite stainless steel especially has low attenuation and because the hardness of martensite stainless steel can be increased through quenching after a certain process, whereby the abrasion resistance of martensite stainless steel is increased. With the absence of a certain process, such as lapping, in the present example as described above, the to-be-bonded surface of the elastic body 3 is formed only through quenching after rolling, that is, through plastic forming. While there are various types of surfaces obtained through rolling, an appropriate surface roughness selected allows the surface to have sufficient adhesive strength. A surface roughness Ra desirably falls between 0.025 µm and 0.2 µm. This is because a certain level of surface roughness increases the anchor effect and the surface area, whereby the adhesive strength of the surface is increased.

A second example will now be described. A vibration wave motor can be used, for example, for driving a lens of an imaging apparatus (optical apparatus). An example will be described of an imaging apparatus using a vibration wave motor for driving a lens arranged in a lens barrel.

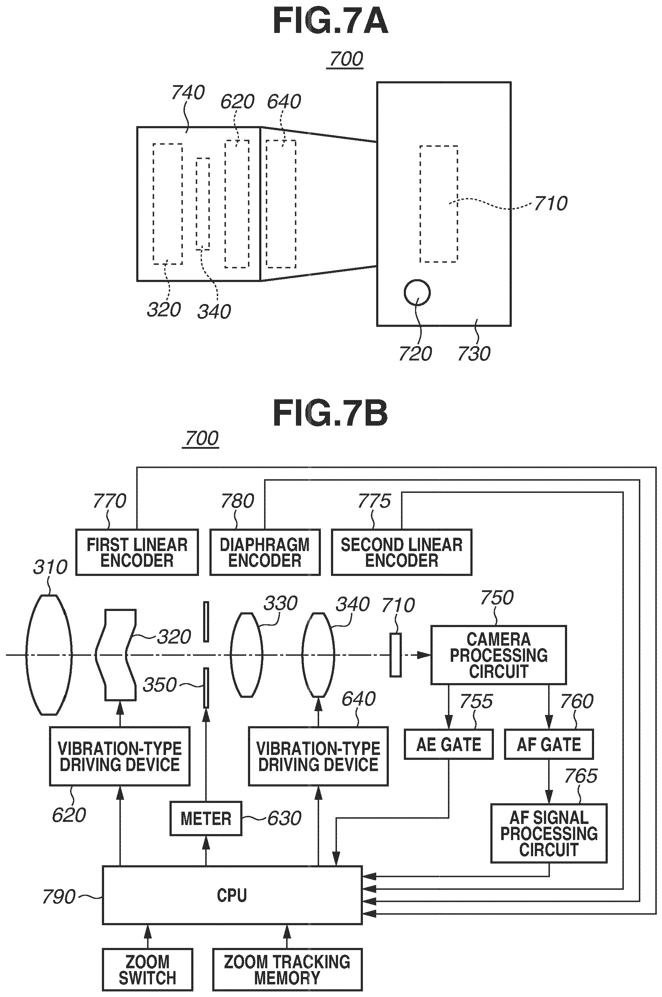

Fig. 7A is a top view illustrating a schematic configuration of an imaging apparatus 700. The imaging apparatus 700 includes a camera main body 730 provided with an image pickup element 710 and a power button 720. The imaging apparatus 700 also includes a lens barrel 740 including a fist lens group (not illustrated), a second lens group 320, a third lens group (not illustrated), a fourth lens group 340, and vibration-type driving devices 620 and 640. The lens barrel 740 is exchangeable as an exchangeable lens. The lens barrel 740 appropriate for a subject to be image-captured can be attached to the camera main body 730. In the imaging apparatus 700, the second lens group 320 and the fourth lens group 340 are respectively driven by the two vibration-type driving devices 620 and 640.

While a detailed configuration of the vibration-type driving device 620 is not illustrated, the vibration-type driving device 620 includes a vibration wave motor and a driving circuit for the vibration wave motor. The vibration-type driving device 620 moves the second lens group 320 in optical axis directions. The vibration-type driving device 640 has a configuration similar to that of the vibration-type driving device 620, and moves the fourth lens group 340 in the optical axis directions.

Fig. 7B is a block diagram illustrating a schematic configuration of the imaging apparatus 700. A first lens group 310, the second lens group 320, a third lens group 330, the fourth lens group 340, and a light amount adjustment unit 350 are arranged at respective predetermined positions on the optical axis inside the lens barrel 740. Light that has passed through the first lens group 310 to the fourth lens group 340 and the light amount adjustment unit 350 forms an image on the image pickup element 710. The image pickup element 710 converts an optical image into an electric signal, and outputs and transmits the electric signal to a camera processing circuit 750.

The camera processing circuit 750 performs amplification, gamma correction, or other processing on the output signal from the image pickup element 710. The camera processing circuit 750 is connected to a central processing unit (CPU) 790 via an automatic exposure (AE) gate 755, and is connected to the CPU 790 via an auto focus (AF) gate 760 and an AF signal processing circuit 765. A video signal subjected to predetermined processing in the camera processing circuit 750 is transmitted to the CPU 790 via the AE gate 755, the AF gate 760, and the AF signal processing circuit 765. The AF signal processing circuit 765 extracts a high frequency component of the video signal, generates an evaluation value signal for AF, and supplies the generated evaluation value signal to the CPU 790.

The CPU 790 is a control circuit that generally controls the operation of the imaging apparatus 700, and generates a control signal for determining exposure and focusing from the acquired video signal. The CPU 790 controls the driving of the vibration-type driving devices 620 and 640 and a meter 630 so that the determined exposure and an appropriate focus state can be obtained, and adjusts respective positions in the optical axis direction of the second lens group 320, the fourth lens group 340, and the light amount adjustment unit 350. Under control of the CPU 790, the vibration-type driving device 620 moves the second lens group 320 in the optical axis direction, the vibration-type driving device 640 moves the fourth lens group 340 in the optical axis direction, and the light amount adjustment unit 350 is subjected to drive control by the meter 630.

The position in the optical axis direction of the second lens group 320 driven by the vibration-type driving device 620 is detected by a first linear encoder 770. The detection result is notified to the CPU 790, and is fed back to the driving of the vibration-type driving device 620. Similarly, the position in the optical axis direction of the fourth lens group 340 driven by the vibration-type driving device 640 is detected by a second linear encoder 775. The detection result is notified to the CPU 790, and is fed back to driving of the vibration-type driving device 640. The position in the optical axis direction of the light amount adjustment unit 350 is detected by a diaphragm encoder 780. The detection result is notified to the CPU 790, and is fed back to driving of the meter 630.

While the description has been given of the optical apparatus having the configuration using the above-mentioned vibration-type actuator to drive an optical element, such as a lens, the optical apparatus may have a configuration using the vibration-type actuator to drive an image pickup element or both the optical element and the image pickup element. That is, the optical apparatus including at least one of the optical element or the image pickup element and using the above-mentioned vibration-type actuator to drive at least one of the optical element and the image pickup element can be provided.

This vibration-type actuator can be used in other electronic apparatuses without any restriction. The electronic apparatus using the above-mentioned vibration-type actuator to dive a target member can be provided.

The vibration wave motor with high output power and high adhesion reliability can be provided. Further, the electronic including the vibration wave motor can be provided.

While the present disclosure has been described with reference to examples, it is to be understood that the disclosure is not limited to the disclosed examples. The scope of the following claims is to encompass all such modifications.

## Claims

1. A vibration-type actuator (2) comprising:
a vibration body including an electro-mechanical energy conversion element (4) and an elastic body (3) which are bonded to each other via an adhesive (13); and
a contact body (9) in contact with the elastic body,
wherein the vibration body and the contact body are configured to be relatively moved by vibrations of the vibration body,
wherein the elastic body includes:
a flat plate portion (3b) that is bonded to the electro-mechanical energy conversion element via the adhesive; and
a protrusion (3a) that is continuous to the flat plate portion and that protrudes from the flat plate portion,
**characterized by** the vibration-type actuator further comprising: as part of the adhesive, between the electro-mechanical energy conversion element and the flat plate portion,
a first adhesive layer (13a); and
a second adhesive layer (13b) that is adjacent to the first adhesive layer, a thickness of the second adhesive layer being larger than a thickness of the first adhesive layer and increasing toward the protrusion, or
a third adhesive layer (13c) that is adjacent to the first adhesive layer and that is between the first adhesive layer and an edge portion of the electro-mechanical energy conversion element, a thickness of the third adhesive layer increasing toward the edge portion and being 10 µm or less, and a length (L3) of the third adhesive layer being between 100 µm and 400 µm.

2. The vibration-type actuator according to claim 1, wherein the thickness of the first adhesive layer is 3 µm or less, and the thickness of the second adhesive layer is between 3 µm and 10 µm.

3. The vibration-type actuator according to claim 1 or 2,
wherein a curved portion of the elastic body, comprising a curved surface different from a linear surface of the flat plate portion that is adjacent to the second adhesive layer, is formed at a root of the protrusion, and
wherein a length (L2) in a radial direction of the protrusion on the second adhesive layer in a section from an end portion of the first adhesive layer adjacent to the second adhesive layer to a point where the curved portion abuts the flat plate portion is between 100 µm and 400 µm.

4. The vibration-type actuator according to any one of claims 1 to 3, further comprising an adhesive pool that is adjacent to the second adhesive layer not on the first adhesive layer side.

5. The vibration-type actuator according to any one of the preceding claim, wherein the elastic body is made of martensite stainless steel, and a surface of the elastic body on the electro-mechanical energy conversion element side is a surface formed through quenching after rolling.

6. The vibration-type actuator according to claim 5, wherein a surface roughness Ra of the surface is between 0.025 µm and 0.2 µm.

7. The vibration-type actuator according to any one of the preceding claims, wherein a difference between a maximum value and minimum value of a thickness of the flat plate portion is 10 µm or less.

8. An optical apparatus comprising:
the vibration-type actuator according to any one of claims 1 to 7; and
at least one of an optical element and an image pickup element configured to be driven by the vibration-type actuator.

9. An electronic apparatus comprising:
a member; and
the vibration-type actuator according to any one of claims 1 to 7, the vibration-type actuator being configured to drive the member.

## Patentansprüche

1. Aktuator vom Vibrationstyp (2), umfassend:
einen Vibrationskörper, der ein Element zur elektromechanischen Energieumwandlung (4) und einen elastischen Körper (3) enthält, die über einen Klebstoff (13) miteinander gebondet sind; und
einen Kontaktkörper (9) in Kontakt mit dem elastischen Körper,
wobei der Vibrationskörper und der Kontaktkörper konfiguriert sind, durch Vibrationen des Vibrationskörpers relativ bewegt zu werden,
wobei der elastische Körper enthält:
einen flachen Plattenabschnitt (3b), welcher über den Klebstoff mit dem Element zur elektromechanischen Energieumwandlung gebondet ist; und
einen Vorsprung (3a), welcher bezüglich eines flachen Plattenabschnitts fortlaufend ist und der vom flachen Plattenabschnitt vorsteht,
**dadurch gekennzeichnet, dass** der Aktuator vom Vibrationstyp ferner umfasst: als Teil des Klebstoffs zwischen dem Element zur elektromechanischen Energieumwandlung und dem flachen Plattenabschnitt
eine erste Klebstoffschicht (13a); und
eine zweite Klebstoffschicht (13b), welche an die erste Klebstoffschicht angrenzt, wobei eine Dicke der zweiten Klebstoffschicht größer als eine Dicke der ersten Klebstoffschicht ist und zum Vorsprung hin zunimmt, oder
eine dritte Klebstoffschicht (13c), welche an die erste Klebstoffschicht angrenzt und die zwischen der ersten Klebstoffschicht und einem Randabschnitt des Elements zur elektromechanischen Energieumwandlung liegt, wobei eine Dicke der dritten Klebstoffschicht zum Randabschnitt hin zunimmt und 10 µm oder weniger beträgt und eine Länge (L3) der dritten Klebstoffschicht zwischen 100 µm und 400 µm liegt.

2. Aktuator vom Vibrationstyp nach Anspruch 1, wobei die Dicke der ersten Klebstoffschicht 3 µm oder weniger beträgt und die Dicke der zweiten Klebstoffschicht zwischen 3 µm und 10 µm liegt.

3. Aktuator vom Vibrationstyp nach Anspruch 1 oder 2,
wobei ein gekrümmter Abschnitt des elastischen Körpers, der eine gekrümmte Oberfläche umfasst, die sich von einer geraden Oberfläche des flachen Plattenabschnitts unterscheidet und die an die zweite Klebstoffschicht angrenzt, an einem Fuß des Vorsprungs ausgebildet ist, und
wobei eine Länge (L2) in einer radialen Richtung des Vorsprungs auf der zweiten Klebstoffschicht in einem Abschnitt von einem Endabschnitt der ersten Klebstoffschicht, welcher an die zweite Klebstoffschicht angrenzt, zu einem Punkt, an welchem der gekrümmte Abschnitt an den flachen Plattenabschnitt angrenzt, zwischen 100 µm und 400 µm liegt.

4. Aktuator vom Vibrationstyp nach einem der Ansprüche 1 bis 3, ferner umfassend eine Klebstoffansammlung, welche an die zweite Klebstoffschicht angrenzt, nicht auf der Seite der ersten Klebstoffschicht.

5. Aktuator vom Vibrationstyp nach einem der vorhergehenden Ansprüche, wobei der elastische Körper aus martensitischem Edelstahl hergestellt ist und eine Oberfläche des elastischen Körpers auf der Seite des Elements zur elektromechanischen Energieumwandlung eine Oberfläche ist, die durch Abschrecken nach dem Walzen ausgebildet ist.

6. Aktuator vom Vibrationstyp nach Anspruch 5, wobei eine Oberflächenrauheit Ra der Oberfläche zwischen 0,025 µm und 0,2 µm liegt.

7. Aktuator vom Vibrationstyp nach einem der vorhergehenden Ansprüche, wobei eine Differenz zwischen einem Maximalwert und einem Minimalwert einer Dicke des flachen Plattenabschnitts 10 µm oder weniger beträgt.

8. Optische Vorrichtung, umfassend:
den Aktuator vom Vibrationstyp nach einem der Ansprüche 1 bis 7; und
mindestens eines von einem optischen Element und einem Bildaufnahmeelement, das konfiguriert ist, durch den Aktuator vom Vibrationstyp angetrieben zu werden.

9. Elektronische Vorrichtung, umfassend:
ein Element; und
den Aktuator vom Vibrationstyp nach einem der Ansprüche 1 bis 7, wobei der Aktuator vom Vibrationstyp konfiguriert ist, das Element anzutreiben.

## Revendications

1. Actionneur de type vibrant (2) comprenant :
un corps vibrant comportant un élément de conversion d'énergie électromécanique (4) et un corps élastique (3) qui sont liés entre eux via un adhésif (13) ; et
un corps de contact (9) en contact avec le corps élastique, dans lequel le corps vibrant et le corps de contact sont configurés pour être déplacés relativement par des vibrations du corps vibrant,
dans lequel le corps élastique comporte :
une partie plaque plate (3b) qui est liée à l'élément de conversion d'énergie électromécanique via l'adhésif ; et
une saillie (3a) qui est continue par rapport à la partie plaque plate et qui fait saillie à partir de la partie plaque plate,
**caractérisé en ce que** l'actionneur de type vibrant comprend en outre : faisant partie de l'adhésif, entre l'élément de conversion d'énergie électromécanique et la partie plaque plate,
une première couche d'adhésif (13a) ; et
une deuxième couche d'adhésif (13b) qui est adjacente à la première couche d'adhésif, une épaisseur de la deuxième couche d'adhésif étant supérieure à une épaisseur de la première couche d'adhésif et augmentant vers la saillie, ou
une troisième couche d'adhésif (13c) qui est adjacente à la première couche d'adhésif et qui se trouve entre la première couche d'adhésif et une partie bord de l'élément de conversion d'énergie électromécanique, une épaisseur de la troisième couche d'adhésif augmentant vers la partie bord et étant de 10 µm ou moins, et une longueur (L3) de la troisième couche d'adhésif étant comprise entre 100 µm et 400 µm.

2. Actionneur de type vibrant selon la revendication 1, dans lequel l'épaisseur de la première couche d'adhésif est de 3 µm ou moins, et l'épaisseur de la deuxième couche d'adhésif est comprise entre 3 µm et 10 µm.

3. Actionneur de type vibrant selon la revendication 1 ou 2, dans lequel une partie incurvée du corps élastique, comprenant une surface incurvée différente d'une surface linéaire de la partie plaque plate qui est adjacente à la deuxième couche d'adhésif, est formée au niveau d'une base de la saillie, et
dans lequel une longueur (L2) dans une direction radiale de la saillie sur la deuxième couche d'adhésif, dans une section allant d'une partie d'extrémité de la première couche d'adhésif adjacente à la deuxième couche d'adhésif jusqu'à un point où la partie incurvée vient en butée contre la partie plaque plate, est comprise entre 100 µm et 400 µm.

4. Actionneur de type vibrant selon l'une quelconque des revendications 1 à 3, comprenant en outre un réservoir d'adhésif qui est adjacent à la deuxième couche d'adhésif, mais ne se trouve pas du côté de la première couche d'adhésif.

5. Actionneur de type vibrant selon l'une quelconque des revendications précédentes, dans lequel le corps élastique est en acier inoxydable martensitique, et la surface du corps élastique du côté de l'élément de conversion d'énergie électromécanique est une surface formée par trempe après laminage.

6. Actionneur de type vibrant selon la revendication 5, dans lequel une rugosité de surface Ra de la surface est comprise entre 0,025 µm et 0,2 µm.

7. Actionneur de type vibrant selon l'une quelconque des revendications précédentes, dans lequel une différence entre une valeur maximale et une valeur minimale d'une épaisseur de la partie plaque plate est de 10 µm ou moins.

8. Appareil optique comprenant :
l'actionneur de type vibrant selon l'une quelconque des revendications 1 à 7 ; et
au moins l'un parmi un élément optique et un élément de prise d'image configuré pour être entraîné par l'actionneur de type vibrant.

9. Appareil électronique comprenant :
un organe ; et
l'actionneur de type vibrant selon l'une quelconque des revendications 1 à 7, l'actionneur de type vibrant étant configuré pour entraîner l'organe.
